# EUROPÄISCHE PATENTSCHRIFT

(11) **EP 1 142 462 B1**
(45) Veröffentlichungstag und Bekanntmachung des Hinweises auf die Patenterteilung: **29.05.2002**
(21) Anmeldenummer: 99966825.4
(22) Anmeldetag: 01.12.1999
(51) Int. Cl.: H05K 13/04

(54) **VORRICHTUNG UND VERFAHREN ZUM BEARBEITEN VON SUBSTRATEN**
DEVICE AND METHOD FOR TREATING SUBSTRATES
DISPOSITIF ET PROCEDE POUR TRAITER DES SUBSTRATS

(30) Priorität: 11.12.1998 DE 19857331
(43) Veröffentlichungstag der Anmeldung: 10.10.2001
(73) Patentinhaber: Siemens Production and Logistics Systems AG, 90475 Nürnberg (DE)
(72) Erfinder: MELF, Johann, D-82541 Münsing (DE)
(74) Vertreter: Berg, Peter
(86) Internationale Anmeldenummer: DE9903841
(87) Internationale Veröffentlichungsnummer: WO0036896

(56) Entgegenhaltungen:
- EP-A- 0 749 270
- WO-A-96/01036
- WO-A-98/37744
- US-A- 4 612 700
- US-A- 4 916 340
- US-A- 5 113 581
- PATENT ABSTRACTS OF JAPAN vol. 007, no. 233 (E-204), 15. Oktober 1983 (1983-10-15) & JP 58 122728 A (NIPPON DENSHIN DENWA KOSHA), 21. Juli 1983 (1983-07-21)

## Beschreibung

Die Erfindung bezieht sich auf eine Vorrichtung und ein Verfahren zum Bearbeiten von Substraten, insbesondere zum Bestücken der Substrate mit elektrischen Bauelementen.

Zum Bearbeiten von Substraten (beispielsweise Leiterplatten oder Keramiksubstraten), beispielsweise durch Bohren von Löchern in die Substrate, durch Setzen von Klebepunkten auf die Substrate oder auch durch die Bestückung von Substraten mit Bauelementen gibt es das Prinzip, daß ein Bearbeitungskopf, der mit Bearbeitungswerkzeugen zum Bearbeiten der Substrate ausgestattet ist, in einer im wesentlichen senkrecht oberhalb des Substrats liegenden Ebene verfahren wird. Dadurch kann der Bearbeitungskopf alle Positionen oberhalb des Substrats erreichen und an der erreichten Position die entsprechende Bearbeitung vornehmen. Die vorliegende Erfindung wird nun am Beispiel des Bestückens von Substraten mit Bauelementen näher beschrieben, sie kann allerdings auch bei anderen Bearbeitungen, wie z.B. den bereits geschilderten, eingesetzt werden.

Bei der automatischen Bestückung von Substraten (beispielsweise Leiterplatten oder Keramiksubstraten) mit SMD-Bauelementen (SMD = Surface mounted device) werden die einzelnen Bauelemente mittels eines Bestückkopfes aus einer Zuführeinrichtung entnommen und dann in einer vorgegebenen Lage auf dem Substrat positioniert. Der Bestückkopf wird dazu in einer Ebene parallel zum Substrat (X, Y-Richtung) verfahren.

Aus WO 98/37744 ist beispielsweise eine Vorrichtung zum Herstellen von elektrischen Baugruppen bekannt, welche ein Chassis mit zwei zueinander im wesentlichen parallelen linearen Längsführungen für zumindest zwei darauf fahrbare zum Beispiel balkenartige Wagen aufweist, die mit jeweils einem Querträger versehen sind, der eine zur Längsführung querstehende Querführung für zumindest einen darauf fahrbaren Bestückkopf aufweist. Zum Verfahren des balkenartigen Wagens (Positionierarm) ist dabei ein Linearmotor vorgesehen, dessen Magnetschiene sich über die gesamte Länge der Längsführung erstreckt und in den zentralen Längsträger eingelassen ist. Der elektromotorisch aktive Teil (Läufer) ist dabei am Positionierarm festigt.

Aus WO 96/01036 ist eine Vorrichtung zur Handhabung von Teilen mit mindestens einer Saugpipette bekannt, bei der eine Druckluftleitung von einer Druckluftquelle zu einer pneumatischen Vorrichtung im Bestückkopf vorgesehen ist, wobei die pneumatische Vorrichtung über eine Saugpumpe die Druckluft in Saugluft zum Ansaugen der Bauelemente umwandelt, und die Druckluft zum Absetzen der Bauelemente auf dem Substrat verwendet.

Die unter Betriebsbedingungen entstehende Wärme der Linearmotoren ist abzuführen. Dabei ist zu berücksichtigen, daß für eine genaue Positionierung des Bestückkopfes möglichst wenig Wärme auf den Positionierarm übergehen soll, um eine genaue Positionierung des Bestückkopfes sicherzustellen. Aus US 4,612,700 ist zur Kühlung eines Motors einer Vorrichtung zum Bestücken von Leiterplatten mit Stiften dafür beispielsweise ein Gebläse bekannt, welches einen Linearmotor allerdings nur in einer Position effektiv kühlen könnte, in den anderen Positionen würde zuviel Wärme auf den Positionierarm übertragen.

Aus US 5,113,581 ist ein Bestückungsautomat bekannt, der Leiterplatten mit oberflächenmontierbaren Bauelementen nach dem TAB-Verfahren bestückt. Zum Kühlen der durch einen Heitblock der Bondvorrichtung ragenden Sangpipette wird ein Kühlgas durch eine Ummantelung der Sangpipette geleitet.

Es ist daher die Aufgabe der Erfindung eine Vorrichtung und ein Verfahren zum Bearbeiten von Substraten anzugeben, wobei die Kühlung in jeder Position des elektromotorischen Antriebes sichergestellt ist, so daß möglichst wenig Wärme auf die Haltevorrichtung des Bearbeitungskopfes übertragen wird und mit Rücksicht auf die zu bewegenden Massen eine möglichst kleine Baugröße des Motors ausgewählt werden kann.

Die Aufgabe wird erfindungsgemäß gelöst mit einer Vorrichtung der eingangs genannten Art mit den kennzeichnenden Merkmalen des Patentanspruches 1 oder des Patentanspruchs 8 und ein Verfahren der eingangs genannten Art mit den kennzeichnenden Merkmalen des Anspruchs 9.

Dabei sind Kühlkanäle in der Umgebung des elektromotorischen Antriebes vorgesehen, durch die die Luftleitungen verlaufen, bevor sie den Bearbeitungskopf erreichen. Durch die Verwendung der im Bearbeitungskopf benötigten Druck- bzw. Saugluft werden Kosten und Aufwand für eine weitere Verbindung mit Druck- bzw. Saugluft eingespart.

In einer besonderen Ausgestaltung der Vorrichtung nach Anspruch 2 und des Verfahrens nach Anspruch 10 wird als Bearbeitungskopf ein Bestückkopf und als Werkzeug eine Saugpipette eingesetzt. Im Gegensatz zur Verwendung von Saugluft hat die Verwendung von Druckluft den Vorteil, daß durch die dadurch verwendete Luftmenge ein ausreichender Wärmeabfluß gewährleistet ist. Damit können auch Motoren mit kleiner Baugröße eingesetzt werden, die mehr Wärme entwickeln als Motoren mit großer Baugröße.

Besonders geeignet ist die Vorrichtung zur Kühlung eines Linearmotors gemäß Anspruch 3, da in diesem Fall der elektromotorisch aktive Teil zusammen mit dem Positionierarm bewegt wird.

Eine besonders effiziente Reduzierung des Wärmeübergangs zwischen dem elektromotorischen Antrieb und dem Positionierarm ergibt sich durch die Anordnung der Kühlkanäle zwischen dem Antrieb und dem Positionierarm gemäß Anspruch 4.

Eine besonders einfache Ausführung ergibt sich durch die Verwendung eines Zwischenstückes gemäß Patentanspruch 5, welches den Positionierarm mit dem Läufer des Linearmotors verbindet und welches die Kühlkanäle für die Druckluftleitungen aufnimmt.

Gemäß Anspruch 6 ist zusätzlich zur besseren Wärmeisolierung zwischen dem Zwischenstück und dem Positionierarm eine Wärmeisolationsplatte angeordnet.

In vorteilhafter Weise läßt sich gemäß Anspruch 7 auch ein weiterer elektromotorischer Antrieb, beispielsweise ein rotatorischer Motor, mit Hilfe der erfindungsgemäßen Vorrichtung kühlen. Dieser rotatorischer Motor ist für die Bewegung des Bestückkopfes entlang des Positionierarmes vorgesehen und treibt über eine ihm zugeordnete Spindel einen Riemen zur Bewegung des Bestückkopfes an. Damit auch der rotatorische Motor gekühlt wird, ist er in der Umgebung der Kühlkanäle angeordnet, beispielsweise mit dem Zwischenstück verbunden.

Anhand der Figuren der.Zeichnung wird die Erfindung mit Hilfe eines Ausführungsbeispieles näher erläutert.

Dabei zeigen:
- Figur 1: eine schematische Seitenansicht einer Vorrichtung zum Bearbeiten von Substraten, mit einem Querschnitt des elektromotorischen Antriebes,
- Figur 2: eine schematische Draufsicht auf eine Vorrichtung zum Bearbeiten von Leiterplatten von Substraten,
- Figur 3: einen detaillierteren Querschnitt in Seitenansicht durch die Verbindung von elektromotorischem Antrieb und Positionierarm,
- Figur 4: in detaillierterer Darstellung einen zusätzlich angeordneten rotatorischen Motor und
- Figur 5: eine schematische Seitenansicht einer Vorrichtung zum Bearbeiten von Substraten unter Verwendung von Saugluft.

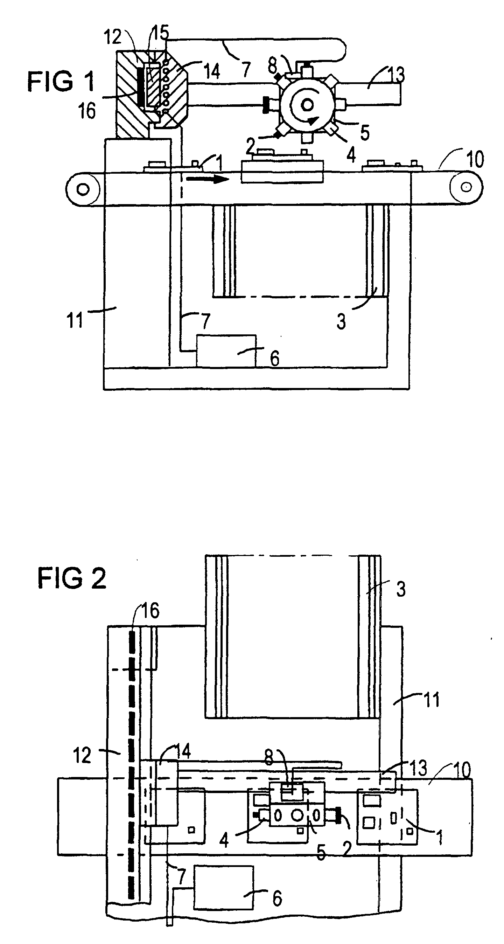

Figur 1 zeigt in einer Seitenansicht und Figur 2 in einer Draufsicht eine Vorrichtung zum Bearbeiten von Substraten 1. Dabei werden Bauelemente 2 aus einer Zuführeinrichtung 3 mittels Saugpipetten 4, die an einen Bestückkopf 5 befestigt sind, entnommen und in einer vorgegebenen Position auf dem Substrat 1 abgesetzt. Eine Druckluftquelle 6 versorgt über eine Druckluftleitung 7 eine im Bestückkopf 5 angeordnete pneumatische Vorrichtung 8, die die Druckluft über eine nicht dargestellte Saugpumpe in Saugluft zum Ansaugen der Bauelemente umwandelt, und die Druckluft verwendet, um die Bauelemente mit Druck auf das Substrat 1 abzusetzen. Die Substrate 1, beispielsweise Leiterplatten, werden dabei mit Hilfe einer Transportvorrichtung 10 von einem nicht dargestellten Vorratsbehälter zur Bestückposition transportiert und nach dem Bestückprozess zu weiteren Bearbeitungsstationen bewegt. Zur Bewegung des Bestückkopfes zwischen den Zuführeinrichtungen 3 und den Substraten 1 sowie zwischen unterschiedlichen Positionen auf dem Substrat 1 dient ein in paralleler Längsrichtung zum Substrat angeordneter Träger 12 sowie ein quer dazu ebenfalls parallel zum Substrat 1 angeordneter Positionierarm 13. Entlang des Trägers 12 ist eine Magnetschiene 16 angeordnet, die den statischen Teil eines Linearmotors bildet, während der mobile Teil durch einen Läufer 15 gebildet wird, der mit einem Ende des Positionierarms 13 verbunden ist. Durch diesen Linearmotor wird der Positionierarm 13 in Längsrichtung entlang des Trägers 12 verfahren. Die Verbindung zwischen dem Positionierarm 13 und dem Läufer 15 verfolgt über ein Zwischenstück 14, durch das in der Nähe des Läufers 15 Kühlkanäle 17 laufen. Diese Kühlkanäle 17 sind als Teil der Druckluftleitung 7 ausgebildet, wodurch eine Luftkühlung des Läufers 15 bewirkt wird.

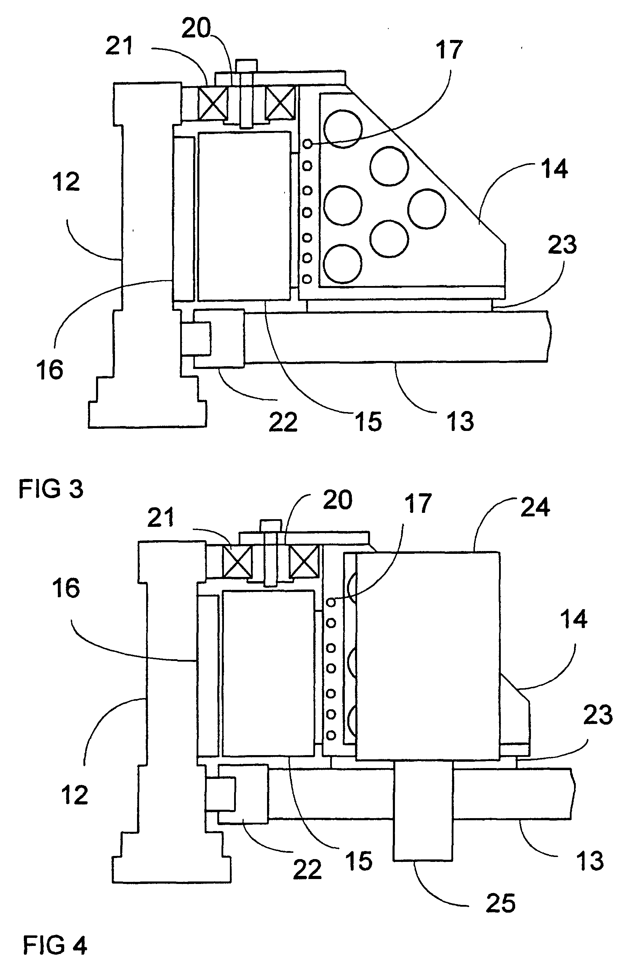

In Figur 3 ist die Führung des Positionierarms 13 im Verhältnis zum sich in Längsrichtung erstreckenden Trägers 12 detaillierter dargestellt. Der Läufer 15 als elektromotorisch bewegtes Teil des Linearmotors ist über ein Zwischenstück 14 mit dem Positionierarm 13 verbunden. Das Zwischenstück ist über eine Stützschiene 20 und Stützrollen 21 mit dem Träger verbunden, welches die Führung 22 zwischen dem Träger 12 und dem Positionierarm unterstützt. Eine weitere Verminderung des Wärmeübergangs zwischen dem Läufer 15 und dem Positionierarm 13 wird durch eine Wärmeisolationsplatte 23 zwischen dem Zwischenstück 14 und dem Positionierarm 13 erreicht.

Die Bewegung des Bestückkopfes 5 entlang des Positionierarmes 13 wird durch einen nicht dargestellten Riemen, der über die Spindel 25 eines rotatorischen Motors 24 angetrieben wird, bewirkt. Der rotatorische Motor 24 ist gemäß Figur 4 ebenfalls mit dem Zwischenstück 14 verbunden und wird dadurch durch die Kühlkanäle 17 verlaufende Druckluftleitung 7 ebenfalls gekühlt.

Durch die erfindungsgemäße Vorrichtung wird daher eine effektive Kühlung und ein verminderter Wärmeübergang vom den elektromotorischen Antrieben auf den Positionierarm 13 sichergestellt. Dadurch läßt sich der Bestückvorgang mit der erforderlichen Genauigkeit durchführen.

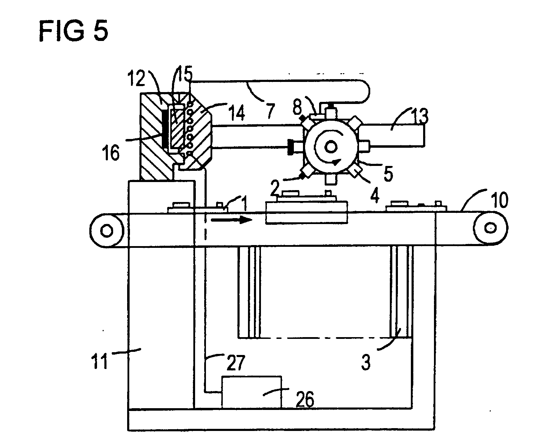

Wie in Figur 5 schematisch dargestellt ist, läßt sich die Erfindung auch bei anderen Bearbeitungsköpfen einsetzen als bei Bestückköpfen 5. So läßt sich beispielsweise bei an Haltevorrichtungen befindlichen Bearbeitungsköpfen 5, die Bohrer als Werkzeuge aufweisen, die zum Absaugen bzw. Wegblasen von Bohrabfall genutzte Saug- bzw. Druckluft für die Kühlung der entsprechenden elektromotorischen Antriebe für die Bewegung in der Ebene parallel zum Substrat zu verwenden. Mithilfe solcher Bohrer werden beispielsweise Löcher in Leiterplatten gebohrt. Anstelle der Druckluftquelle 6 wird in diesem Fall eine Pumpe 26 eingesetzt, so daß die Kühlung über durch Saugluftleitungen 27 (anstelle der Druckluftleitungen 7) transportierte Saugluft erfolgt.

## Patentansprüche

1. Vorrichtung zum Bearbeiten von Substraten (2),
mit einem Bearbeitungskopf (5) mit mindestens einem Bearbeitungswerkzeug (4) zum Bearbeiten der Substrate (2),
mit einer Druckluftquelle (6) und mit von der Druckluftquelle (6) zum Bearbeitungskopf (5) verlaufenden Druckluftleitungen (7),
mit einer pneumatischen Vorrichtung (8) im Bearbeitungskopf (5), die die über die Druckluftleitung (7) gelieferte Druckluft zum Bearbeiten des Substrats (2) verwendet,
mit einer Haltevorrichtung (12,13), an der der Bearbeitungskopf (5) verfahrbar aufgehängt ist, um verschiedene Positionen in einer im wesentlichen parallel oberhalb zum Substrat (2) verlaufenden Ebene zu erreichen,
mit mindestens einem elektromotorischen Antrieb (15,16;24) zum Verfahren des Bearbeitungskopfes (5) zwischen den Positionen,
wobei
Kühlkanäle (17) in der Haltevorrichtung (12,13) in der Umgebung des mindestens einen elektromotorischen Antriebs (15,16;24) vorgesehen sind,
die als Teil der Druckluftleitung (7) ausgebildet sind.

2. Vorrichtung zum Bearbeiten von Substraten (2), insbesondere zum Bestücken der Substrate (2) mit elektrischen Bauelementen (1), nach Anspruch 1,
**dadurch gekennzeichnet,**
**daß** der Bearbeitungskopf (5) als Bestückkopf (5) ausgebildet ist,
**daß** die Bearbeitungswerkzeuge als Saugpipetten (4) ausgebildet sind, die die Bauelemente (1) aufnimmt und auf das Substrat aufsetzt,
**daß** die pneumatische Vorrichtung (8) so ausgebildet ist, daß diese die Druckluft zum Ansaugen und Absetzen der Bauelemente (1) verwendet.

3. Vorrichtung zum Bearbeiten von Substraten (2) nach Anspruch 2,
**dadurch gekennzeichnet,**
**daß** die Haltevorrichtung (12,13) einen sich parallel zum Substrat (2) erstreckenden Träger (12) und einen sich parallel zum Substrat (2) und senkrecht zum Träger (12) erstreckenden Positionierarm (13) umfaßt,
**daß** der Bestückkopf (5) am Positionierarm (13) so befestigt ist, daß er entlang des Positionierarms (13) verfahrbar ist, und daß der mindestens eine elektromotorische Antrieb (15,16;24) als Linearmotor (15,16) ausgebildet ist, der den Positionierarm (13) entlang des Trägers (12) bewegt.

4. Vorrichtung zum Bearbeiten von Substraten (2) nach Anspruch 3,
**dadurch gekennzeichnet,**
**daß** der elektromotorische Antrieb (15,16;24) auf der dem Positionierarm (13) abgewandten Seite der Kühlkanäle (17) angeordnet ist.

5. Vorrichtung zum Bearbeiten von Substraten (2) nach einem der Ansprüche 3 oder 4,
**dadurch gekennzeichnet,**
**daß** der Positionierarm (13) über ein Zwischenstück (14) mit einem Läufer (15) des Linearmotors (15,16) verbunden ist und
**daß** die Kühlkanäle (17) im Zwischenstück (14) verlaufen.

6. Vorrichtung zum Bearbeiten von Substraten (2) nach Anspruch 5,
**dadurch gekennzeichnet,**
**daß** zwischen dem Zwischenstück (14) und dem Positionierarm (13) eine Wärmeisolationsplatte (23) angeordnet ist.

7. Vorrichtung zum Bearbeiten von Substraten (2) nach einem der Ansprüche 3 bis 6,
**dadurch gekennzeichnet,**
**daß** ein weiterer elektromotorischer Antrieb als rotatorischer Motor (24) ausgebildet ist, der zusammen mit dem Positionierarm (13) bewegt wird,
**daß** der rotatorische Motor (24) die Bewegung des Bestückkopfes (5) entlang des Positionierarms (13) antreibt und in der Umgebung der Kühlkanäle (17) angeordnet ist.

8. Vorrichtung zum Bearbeiten von Substraten (2),
mit einem Bearbeitungskopf (5) mit mindestens einem Bearbeitungswerkzeug (4) zum Bearbeiten der Substrate (2),
mit einer Pumpe (26) und mit von der Pumpe (26) zum Bearbeitungskopf (5) verlaufenden Saugluftleitungen (27),
mit einer pneumatischen Vorrichtung (8) im Bearbeitungskopf (5), die die über die Saugluftleitung (27) angesaugte Luft zum Bearbeiten des Substrats (2) verwendet,
mit einer Haltevorrichtung (12,13), an der der Bearbeitungskopf (5) verfahrbar aufgehängt ist, um verschiedene Positionen in einer im wesentlichen parallel oberhalb zum Substrat (2) verlaufenden Ebene zu erreichen,
mit mindestens einem elektromotorischen Antrieb (15,16;24)zum Verfahren des Bearbeitungskopfes (5) zwischen den Positionen,
**dadurch gekennzeichnet,**
**daß** Kühlkanäle (17) in der Haltevorrichtung (12,13) in der Umgebung des mindestens einen elektromotorischen Antriebs (15,16;24) vorgesehen sind und
**daß** die Kühlkanäle als Teil der Saugluftleitung (27) ausgebildet sind.

9. Verfahren zum Bearbeiten von Substraten (2) bei dem
ein Bearbeitungskopf (5) mit mindestens einem Bearbeitungswerkzeug (4) an einer Haltevorrichtung (12,13) im wesentlichen in einer im wesentlichen parallel oberhalb des Substrats (2) befindlichen Ebene mittels mindestens eines elektromotorischen Anstriebs (15,16,24) verfahren wird,
eine dem Bearbeitungskopf (5) zugeordnete pneumatische Vorrichtung (8) von einer Druckluftquelle (6) über Druckluftleitungen (7) mit Druckluft versorgt wird, die von der pneumatischen Vorrichtung (8) zum Bearbeiten des Substrats (2) verwendet wird,
wobei
die durch die Druckluftleitungen (7) geleitete Druckluft zum Kühlen des mindestens einen elektromotorischen Antriebs (15,16,24) verwendet wird.

10. Verfahren zum Bearbeiten von Substraten (2) nach Anspruch 9, insbesondere zum Bestücken der Substrate (2) mit elektrischen Bauelementen (1),
**dadurch gekennzeichnet,**
**daß** als Bearbeitungskopf (5) ein Bestückkopf (5) verwendet wird,
**daß** als Bearbeitungswerkzeug eine Saugpipette (4) verwendet wird,
**daß** die pneumatische Vorrichtung (8) die Druckluft zum Ansaugen und Absetzen der Bauelemente verwendet.

## Claims

1. Apparatus for processing substrates (2), having a processing head (5) with at least one processing tool (4) for processing the substrates (2),
having a compressed-air source (6) and compressed-air lines (7) running from the compressed-air source (6) to the processing head (5),
having a pneumatic device (8) in the processing head (5), this pneumatic device (8) using the compressed air, delivered via the compressed-air line (7), for processing the substrate (2),
having a holding device (12, 13) on which the processing head (5) is suspended in a traversable manner in order to reach various positions in a plane running essentially parallel to and above the substrate (2),
having at least one electromotive drive (15, 16; 24) for traversing the processing head (5) between the positions,
cooling passages (17) being provided in the holding device (12, 13) in the vicinity of the at least one electromotive drive (15, 16; 24), these cooling passages (17) being designed as part of the compressed-air line (7).

2. Apparatus for processing substrates (2), in particular for fitting the substrates (2) with electrical components (1), according to Claim 1, **characterized in that** the processing head (5) is designed as a fitting head (5), **in that** the processing tools are designed as suction pipettes (4) which pick up the components (1) and set them down on the substrate, **in that** the pneumatic device (8) is designed in such a way that it uses the compressed air for drawing in and depositing the components (1).

3. Apparatus for processing substrates (2) according to Claim 2, **characterized in that** the holding device (12, 13) comprises a support (12), extending parallel to the substrate (2), and a positioning arm (13) extending parallel to the substrate (2) and perpendicularly to the support (12), **in that** the fitting head (5) is fastened to the positioning arm (13) in such a way that it is traversable along the positioning arm (13), and **in that** the at least one electromotive drive (15, 16; 24) is designed as a linear motor (15, 16) which moves the positioning arm (13) along the support (12).

4. Apparatus for processing substrates (2) according to Claim 3, **characterized in that** the electromotive drive (15, 16; 24) is arranged on the side of the cooling passages (17) which faces away from the positioning arm (13).

5. Apparatus for processing substrates (2) according to either of Claims 3 and 4, **characterized in that** the positioning arm (13) is connected via an intermediate piece (14) to a rotor (15) of the linear motor (15, 16), and **in that** the cooling passages (17) run in the intermediate piece (14).

6. Apparatus for processing substrates (2) according to Claim 5, **characterized in that** a heat-insulation plate (23) is arranged between the intermediate piece (14) and the positioning arm (13).

7. Apparatus for processing substrates (2) according to one of Claims 3 to 6, **characterized in that** a further electromotive drive is designed as a rotary motor (24) which is moved together with the positioning arm (13), **in that** the rotary motor (24) drives the movement of the fitting head (5) along the positioning arm (13) and is arranged in the vicinity of the cooling passages (17).

8. Apparatus for processing substrates (2),
having a processing head (5) with at least one processing tool (4) for processing the substrates (2),
having a pump (26) and suction-air lines (27) running from the pump (26) to the processing head (5),
having a pneumatic device (8) in the processing head (5), this pneumatic device (8) using the air, drawn in via the suction-air line (27), for processing the substrate (2),
having a holding device (12, 13) on which the processing head (5) is suspended in a traversable manner in order to reach various positions in a plane running essentially parallel to and above the substrate (2),
having at least one electromotive drive (15, 16; 24) for traversing the processing head (5) between the positions,
**characterized in that** cooling passages (17) are provided in the holding device (12, 13) in the vicinity of the at least one electromotive drive (15, 16; 24), and **in that** the cooling passages are designed as part of the suction-air line (27).

9. Method of processing substrates (2) in which a processing head (5) having at least one processing tool (4) is traversed on a holding device (12, 13) essentially in a plane located essentially parallel to and above the substrate (2) by means of at least one electromotive drive (15, 16, 24), a pneumatic device (8) assigned to the processing head (5) is supplied with compressed air from a compressed-air source (6) via compressed-air lines (7), this compressed air being used by the pneumatic device (8) for processing the substrate (2), the compressed air directed through the compressed-air lines (7) being used for cooling the at least one electromotive drive (15, 16, 24).

10. Method of processing substrates (2) according to Claim 9, in particular for fitting the substrates (2) with electrical components (1), **characterized in that** a fitting head (5) is used as processing head (5), **in that** a suction pipette (4) is used as processing tool, **in that** the pneumatic device (8) uses the compressed air for drawing in and depositing the components.

## Revendications

1. Dispositif pour le traitement de substrats (2), comportant une tête de traitement (5) avec au moins un outil de traitement (4) pour traiter les substrats (2), avec une source d'air comprimé (6) et des conduits d'air comprimé qui s'étendent entre la source d'air comprimé (6) et la tête de traitement (5), avec dans la tête de traitement (5) un dispositif pneumatique (8) qui utilise pour le traitement du substrat (2) l'air comprimé délivré par l'intermédiaire du conduit d'air comprimé (7), avec un dispositif de maintien (12, 13) sur lequel la tête de traitement (5) est suspendue de manière à pouvoir être déplacée pour atteindre différentes positions dans un plan qui s'étend au-dessus du substrat (2) essentiellement parallèlement à celui-ci, avec au moins un entraînement par moteur électrique (15, 16; 24) pour déplacer la tête de traitement (5) entre les positions, des canaux de refroidissement (17) étant prévus dans le dispositif de maintien (12, 13) au voisinage de l'au moins un entraînement par moteur électrique (15, 16; 24) et étant configurés comme partie du conduit d'air comprimé (7).

2. Dispositif pour le traitement de substrats (2), en particulier pour l'équipement des substrats (2) en composants électriques (1), selon la revendication 1, **caractérisé en ce que** la tête de traitement (5) est configurée comme tête d'équipement (5), **en ce que** les outils de traitement sont configurés comme pipettes d'aspiration (4) qui reçoivent les composants (1) et les déposent sur le substrat, et **en ce que** le dispositif pneumatique (8) est configuré de manière à utiliser l'air comprimé pour aspirer et déposer les composants (1).

3. Dispositif pour le traitement de substrats (2) selon la revendication 2, **caractérisé en ce que** le dispositif de maintien (12, 13) comprend un support (12) qui s'étend en parallèle au substrat (2) et un bras de positionnement (13) qui s'étend parallèlement aux substrats (2) et perpendiculairement au support (12), **en ce que** la tête d'équipement (5) est fixée sur le bras de positionnement (13) de manière à pouvoir être déplacée le long du bras de positionnement (13), et **en ce que** l'au moins un entraînement par moteur électrique (15, 16; 24) est configuré comme moteur linéaire (15, 16) qui déplace le bras de positionnement (13) le long du support (12).

4. Dispositif pour le traitement de substrats (2) selon la revendication 3, **caractérisé en ce que** l'entraînement par moteur électrique (15, 16; 24) est disposé sur le côté du bras de positionnement (13) qui n'est pas tourné vers les canaux de refroidissement (17).

5. Dispositif pour le traitement de substrats (2) selon l'une des revendications 3 ou 4, **caractérisé en ce que** le bras de positionnement (13) est relié par l'intermédiaire d'une pièce intermédiaire (14) à un induit (15) du moteur linéaire (15, 16) et **en ce que** les canaux de refroidissement (17) s'étendent dans la pièce intermédiaire (14).

6. Dispositif pour le traitement de substrats (2) selon la revendication 5, **caractérisé en ce qu'**une plaque d'isolation thermique (23) est disposée entre la pièce intermédiaire (14) et le bras de positionnement (13).

7. Dispositif pour le traitement de substrats (2) selon l'une des revendications 3 à 6, **caractérisé en ce qu'**un autre entraînement par moteur électrique est configuré comme moteur rotatif (24) qui est déplacé en même temps que le bras de positionnement (13), et **en ce que** le moteur rotatif (24) entraîne le déplacement de la tête d'équipement (5) le long du bras de positionnement (13) et est disposé dans l'environnement des canaux de refroidissement (17).

8. Dispositif pour le traitement de substrats (2), comportant une tête de traitement (5) avec au moins un outil de traitement (4) pour traiter les substrats (2), avec une pompe (26) et des conduits d'aspiration d'air (27) qui s'étendent entre la pompe (26) et la tête de traitement (5), avec dans la tête de traitement (5) un dispositif pneumatique (8) qui utilise pour le traitement du substrat (2) l'air aspiré par l'intermédiaire du conduit d'aspiration d'air (27), avec un dispositif de maintien (12, 13) sur lequel la tête de traitement (5) est suspendue de manière à pouvoir être déplacée pour atteindre différentes positions dans un plan qui s'étend au-dessus du substrat (2) essentiellement parallèlement à celui-ci, avec au moins un entraînement par moteur électrique (15, 16; 24) pour déplacer la tête de traitement (5) entre les positions, **caractérisé en ce que** des canaux de refroidissement (17) sont prévus dans le dispositif de maintien (12, 13) au voisinage de l'au moins un entraînement par moteur électrique (15, 16; 24) et **en ce que** les canaux sont configurés comme partie du conduit d'air comprimé (7).

9. Procédé pour le traitement de substrats (2), dans lequel une tête de traitement (5) avec au moins un outil de traitement (4) est déplacé selon un dispositif de maintien (12, 13), essentiellement dans un plan situé au-dessus du substrat (2) et essentiellement parallèle à lui, au moyen d'au moins un entraînement par moteur électrique (15, 16, 24), un dispositif pneumatique (8) associé à la tête de traitement (5) étant alimenté en air comprimé par une source d'air comprimé (6) et par l'intermédiaire de conduits d'air comprimé (7), lequel air comprimé est utilisé par le dispositif pneumatique (8) pour le traitement du substrat (2), l'air comprimé conduit par les conduits d'air comprimé (7) étant utilisé pour le refroidissement de l'au moins un entraînement par moteur électrique (15, 16, 24).

10. Procédé pour le traitement de substrats (2), selon la revendication 9, en particulier pour l'équipement des substrats (2) en composants électriques (1), **caractérisé en ce que** l'on utilise comme tête de traitement (5) une tête d'équipement (5), **en ce que** l'on utilise comme outil de traitement une pipette d'aspiration (4) et **en ce que** le dispositif pneumatique (8) utilise l'air comprimé pour aspirer et déposer les composants.
